Europäisches Patentamt

European Patent Office

Office européen des brevets

(19)

(11) EP 0 655 699 B1

(12) EUROPEAN PATENT SPECIFICATION

(45) Date of publication and mention
of the grant of the patent:
**12.01.2000 Bulletin 2000/02**

(51) Int Cl.⁷: **G06F 19/00**, G05D 1/06,
G01C 21/00

(21) Application number: **94308763.5**

(22) Date of filing: **28.11.1994**

(54) **Mission planning cost system**

Kosten-System zur Missionplanung

Système et méthode de coût pour la planification de mission

(84) Designated Contracting States:
**DE FR GB**

(30) Priority: **30.11.1993  US 159651**
             **18.01.1994  US 182891**
             **18.01.1994  US 182894**

(43) Date of publication of application:
**31.05.1995  Bulletin 1995/22**

(73) Proprietor: HONEYWELL INC.
**Minneapolis Minnesota 55408 (US)**

(72) Inventors:
 • **Lippitt, Carl E.**
   **Albuquerque, New Mexico 87111 (US)**
 • **Price, David N.**
   **Melbourne, Florida 32940 (US)**

(74) Representative:
**Fox-Male, Nicholas Vincent Humbert**
**Eric Potter Clarkson**
**Park View House**
**58 The Ropewalk**
**Nottingham NG1 5DD (GB)**

(56) References cited:
**EP-A- 0 337 338        EP-A- 0 453 327**

 • **PROCEEDINGS OF THE IEEE 1990 NATIONAL
   AEROSPACE AND ELECTRONICS
   CONFERENCE, 21 May 1990, US pages 1001 -
   1007 MACMILLAN ET AL 'knowledge based
   route planning'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

Background of the Invention

The invention relates to routing of covert flight paths for maximum terrain masking. More particularly, the invention relates to use of digital terrain elevation data to generate a costing surface which allows superior routing of covert flight paths.

Digital terrain elevation data (DTED) is a digital representation of the topography of a geographical region. DTED is produced from satellite photographs or other means and is available through the Defense Mapping Agency to government contractors on a need-to-know basis. DTED comprises a plurality of digital data points laid out in a grid with a spacing typically on the order of 800 meters between points.

When routing flight paths for covert operations, it is desirable to route the paths such that maximum terrain masking is achieved. Particularly, it is desirable to avoid highly visible areas such as ridge tops and wide open areas.

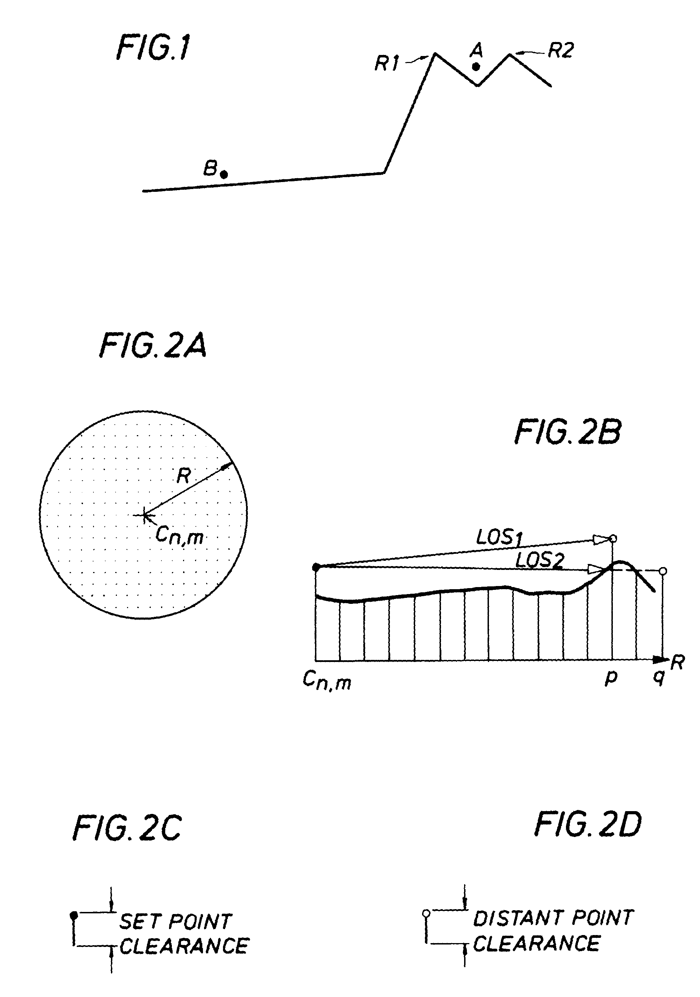

According to the prior art, it is known to route covert flight paths using DTED such that the flight path is always in the lowest local area. This routing method rests on the assumption that the best terrain masking will always be at the lowest local elevation. However, this assumption is not always true, and thus the prior art method frequently results in less than optimum routing of flight paths. For example, consider an airplane flying perpendicular to the plane of the paper along a line through point A in Fig. 1. Because of the high valley created by parallel ridges R1 and R2, the flight path through point A will have excellent terrain masking. Under the prior art assumption that the lowest local elevation has the best terrain masking, however, the prior art routing method will cause the airplane to move from position A to the lower position B in the adjacent valley. Clearly, despite the fact that position B is lower than position A, the terrain masking in the open valley is significantly inferior to the terrain masking at position A. Moreover, in order to move from position A to position B, the flight path must move over ridge R1, i.e., through a highly visible area where detection is likely. Thus, the prior art routing method cannot be used to provide reliable terrain-masked covert flight paths.

The use of local minimums in DTED to route covert flight paths also neglects the importance of the roughness or "flyability" of the terrain. Where the surface of the local minimum is very rough, it will be difficult for the aircraft to maintain a low altitude flight path. Flying at an increased altitude over low but rough terrain may in many cases be more visible than flying at a lower altitude over flatter, higher terrain. Known methods of routing covert flight paths do not satisfactorily address this issue.

An article entitled "Knowledge based route planning by T. R. MacMillan et al (Proc. IEEE 1990 NASA Conference, 21 May 1990, p1001-1007) refers to a computer system for automatically planning a route and explaining the rationale to the choice made.

Summary of the Invention

The present invention provides apparatus for routing covert flight paths as defined in Claim 1 hereinafter.

The present invention also provides a method of routing covert flight paths as defined in Claim 7 hereinafter.

The invention overcomes the above-described disadvantages of the prior art by providing a costing surface which allows superior routing of covert flight paths.

The present invention may include any one or more features as defined in dependent Claims 2 to 6 or 8 to 13.

In some aspects, the hideability map is formed from the digital terrain elevation data using a line of sight area calculation, and the flyability map is formed from the digital terrain elevation data using a slopeness calculation.

In other aspects, the invention further includes the steps of quantizing the hideability map and quantizing the flyability map prior to forming the costing surface. The step of quantizing the hideability map may in some embodiments include the steps of normalizing points within the hideability map based on a maximum theoretical value and distributing the normalized points into a plurality of quantized levels.

In some embodiments, the weighted combination is performed in accordance with the following formula where Pq is a point within the costing surface, Hq is a quantized hideability value, Fq is a quantized flyability value, and "a" and "b" represent weighting factors between 0 and 255:

$$Pq = \frac{127}{15} \sqrt{\frac{((a)^2 Hq^2 + (b)^2 Fq^2)}{(a^2 + b^2)}}$$

In some aspects, the line of sight area calculation includes the steps of performing a ray trace from one point in the digital terrain elevation data to every other point within a circle of radius "R" centered on the one point; and determining how many of the points within the circle are observable from the one point based on the ray trace.

In some embodiments, the invention relates to a method of forming a costing surface from digital terrain elevation data of a geographical region for use in routing covert flight paths, comprising the steps of forming a hideability map from the digital terrain elevation data by assigning line of sight area values to points within the digital terrain elevation data, the hideability map being indicative of hideable areas within the geographical region; quantizing the hideability map by assigning each of the line of sight area values to one of a set number of quantization levels; forming a flyability map from the digital terrain elevation data by determining slopeness values for points within the digital terrain elevation data, the flyability map being indicative of flyable areas of the geographical region; quantizing the flyability map by assigning each of the slopeness values to one of a plurality of quantization levels; and creating a costing surface from a weighted combination of the quantized hideability map and the quantized flyability map.

Brief Description of the Drawings

Fig. 1 is a diagram illustrating prior art covert flight path routing systems;

Fig. 2a is a schematic diagram illustrating a line of sight area calculation according to an embodiment of the invention;

Fig. 2b is a cross-sectional diagram illustrating a line of sight calculation according to an embodiment of the invention;

Fig. 2c is a schematic diagram illustrating a set point clearance used according to an embodiment of the invention;

Fig. 2d is a schematic diagram illustrating a distant point clearance used according to an embodiment of the invention;

Fig. 3 is a diagram illustrating a "slopeness" calculation according to an embodiment of the invention;

Fig. 4A is a graph showing division of a hideability distribution into bins according to an embodiment of the invention;

Fig. 4B is a graph showing assignment of weighted thresholds according to an embodiment of the invention;

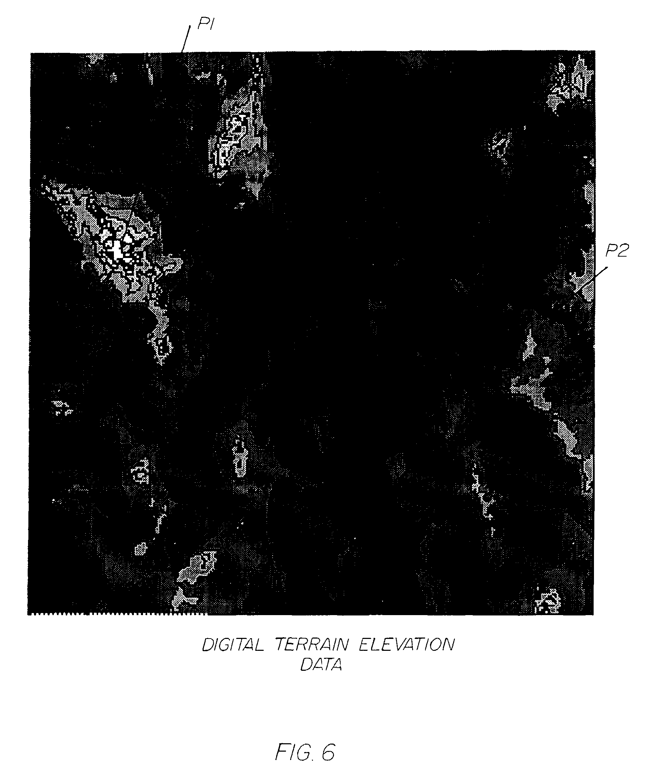

Fig. 5 is a flow chart according to a preferred embodiment of the invention;

Fig. 6 is an exemplary plot of DTED data;

Fig. 7 is a hideability map formed from the DTED of Fig. 6;

Fig. 8 is a flyability map formed from the DTED of Fig. 6; and

Fig. 9 is a costing surface obtained from a weighted combination of the hideability map of Fig. 7 and the flyability map of Fig. 8.

Description of the Preferred Embodiment

A preferred embodiment of the invention will now be described with reference to the accompanying drawings.

According to the invention, a costing surface is generated from the DTED. The costing surface indicates what it "costs" from an observability standpoint to get from a point A to a point B on the surface along a given route. As explained in detail below, the costing surface is formed from a hideability map and a flyability map, each of which is generated individually from the DTED.

The hideability map is indicative of which areas on a given DTED plot are most "hideable", i.e., have the best terrain masking. To generate this map, a "hideability transformation" is performed on the DTED. In the hideability transformation, a line of sight area (LOSA) calculation is made for each DTED point within the plot. Referring to Fig. 2a, for a given point $C_{n,m}$ within the plot, a circle of radius R is drawn around the point so as to encompass a certain number of other data points. A line of sight determination is then made from the point $C_{n,m}$ (called the "set point") to each of the other points in the circle (the "distant points") to determine whether there is a direct line of sight between the two points. Preferably, the set point is biased by a set point clearance (usually on the order of 500 feet) above the local terrain elevation as shown in Fig. 2c. Similarly, the distant points are biased by a distant point clearance (usually on the order of 50 feet) above the distant terrain elevation, as shown in Fig. 2d.

With the set and distant point clearances established, it is determined whether the biased distant point is obstructed by any other terrain point between it and the biased set point. If not, that distant point is said to be observable. For example, referring to Fig. 2b, the set point is illustrated as being 500 feet above the terrain at point $C_{n,m}$. Distant point p, which is fifty feet above the terrain, is observable from set point $C_{n,m}$ as shown by ray $LOS_1$. However, distant point q is not observable from point $C_{n,m}$ because the ray $LOS_2$ intersects with the terrain at point p.

Once the line of sight determination has been conducted with respect to set point $C_{n,m}$ for every point within the circle of radius R, point $C_{n,m}$ is assigned a scalar value indicative of the number of observable points within the area of the circle. This completes the line of sight area ("LOSA") calculation for that point. The LOSA calculation is then repeated for every point $C_{n,m}$ within the plot.

The scalar value assigned to each point $C_{n,m}$ as a result of the LOSA calculation has a defined minimum value of 9 (i.e., the center point itself plus the eight immediately surrounding points are assumed to be observable) and a maximum value defined by $pR^2$ divided by the point spacing (typically 800 meters). R is preferably on the order of thirty miles.

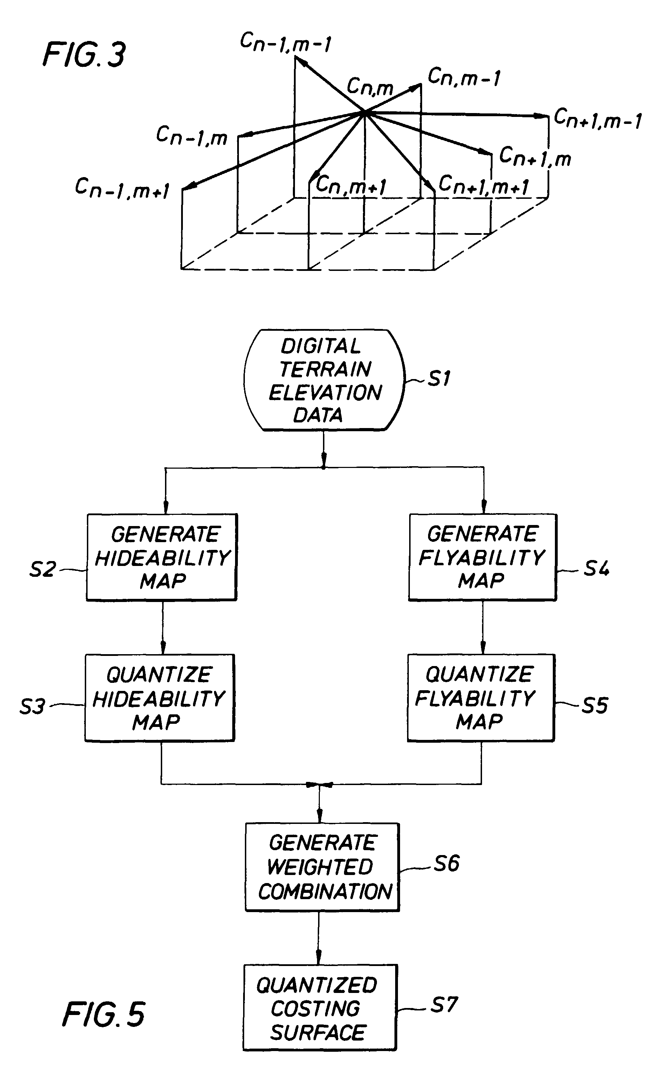

The flyability map is indicative of the roughness of the terrain within a given DTED plot. To generate this map, a "flyability transformation" is performed on the DTED. The flyability transformation involves determining a "slopeness" value for each point $C_{n,m}$ within the DTED plot. To obtain the slopeness value, a value indicative of slope is calculated from point $C_{n,m}$ to each of its eight neighboring points ($C_{n-1,m-1}$ to $C_{n+1,m+1}$) as shown in Fig. 3. The slopeness value is defined as the summation of these eight values. The slopeness value is not actually a slope, since it has not been divided by the point spacing, but it is indicative of the roughness of the terrain at point $C_{n,m}$. This process is then repeated for each point $C_{n,m}$ within the plot. A high slopeness value is indicative of rough terrain, while a low slopeness value indicates that the terrain is relatively flat.

Once the hideability and flyability maps have been obtained, it is necessary to quantize the scalar values assigned to the points in each map for storage purposes. Preferably, each map is quantized to sixteen levels, thus requiring only four bits to store the value at each point.

The quantization of the flyability transformation is straight-forward, and preferably is conducted according to the following table:

| Quantized Value | Slopeness Threshold |
|:---:|:---:|
| 0 | <1000 |
| 1 | <1100 |
| 2 | <1200 |
| 3 | <1300 |
| 4 | <1400 |
| 5 | <1500 |
| 6 | <1600 |
| 7 | <1700 |
| 8 | <1800 |
| 9 | <2000 |
| 10 | <2200 |
| 11 | <2400 |
| 12 | <2800 |
| 13 | <2900 |
| 14 | <3000 |
| 15 | >=3000 |

The non-linear nature of this quantization table allows more important slopeness ranges to be emphasized in the quantized result and less important ranges to be de-emphasized.

The hideability map is also preferably quantized into sixteen levels. To perform this quantization, the LOSA values are first normalized based on the maximum theoretical value, i.e., $pR^2$ divided by the point spacing. Then, thresholds are determined which equalize the normal distribution into 16 levels.

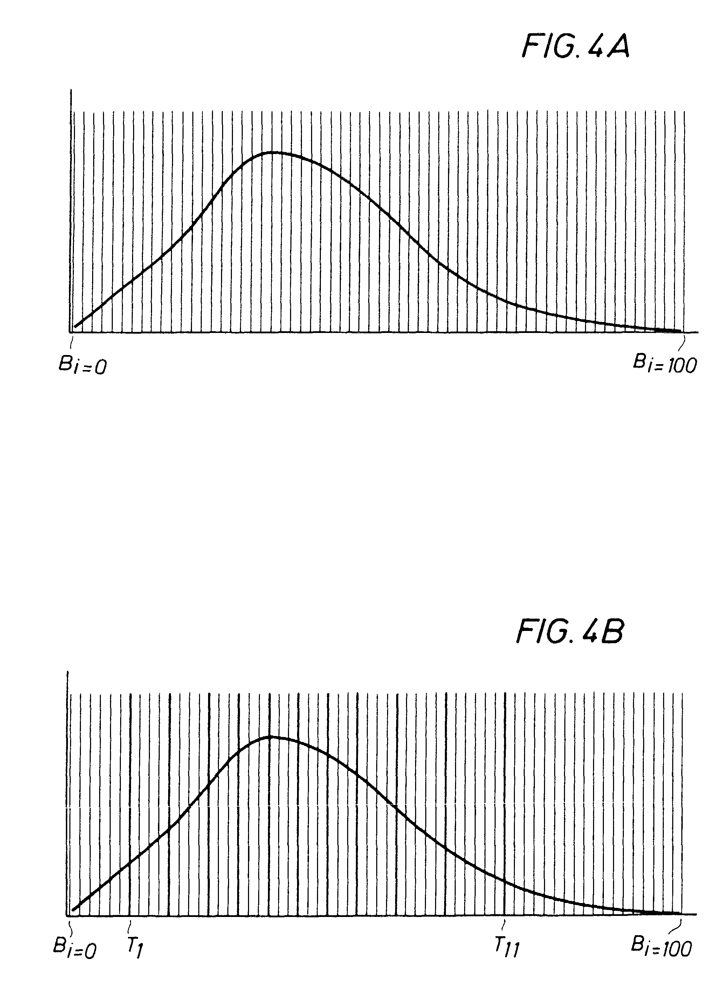

For example, a preferred method for quantizing the hideability map is as follows. First, the distribution of LOSA values is normalized according to the maximum theoretical value, which is approximated as $4pR^2$. The "4" (or $2^2$) in this equation is derived from the fact that for an 800 meter point separation there are approximately two DTED points per nautical mile. Then, the normalized distribution is divided into 100 bins $B_i$ as shown in Fig. 4A. These bins are then assigned to quantization levels by determining weighted thresholds $T_n$ as shown

in Fig. 4B. The weighted thresholds are determined by counting the number of normalized points beginning with bin $B_1$ until 4096 points have been counted. These points then fall into the first of the 16 quantization levels, and the counting re-starts with the next bin. This process ends when all sixteen levels have been assigned or the bins are exhausted. As shown in Fig. 4B, if the bins are exhausted before all 16 levels are assigned, several of the levels may not be used (only 12 levels are assigned in this example). The result is quantization of the hideability map in a way which emphasizes those bins which occur under the "hump" of the distribution.

Following quantization of the hideability and flyability maps, the costing surface is obtained from a weighted combination of the quantized maps. Particularly, if Hq represents a quantized hideability value, Fq represents a quantized flyability value, Pq represents the quantized result, i.e., a point in the costing surface, and "a" and "b" are weighting factors which may range between 0 and 255, then:

$$Pq = \frac{127}{15} \sqrt{\frac{((a)^2 Hq^2 + (b)^2 Fq^2)}{(a^2 + b^2)}}$$

The value of "a" and "b" may vary depending upon the application, but are typically chosen to be on the order of a = 60, b = 100.

The method of generating a costing surface discussed above is illustrated in the flow chart of Fig. 4. In this chart, the process begins in state S1 with a DTED plot of a given geographical area. Then, in step S2 line of sight area calculations are performed to generate a hideability map. In step S3, the hideability map is quantized to facilitate storage. At the same time, in step S4 a flyability map is generated from the DTED, which is then quantized in step S5. A weighted combination of the quantized maps is generated in step S6, resulting in formation of the costing surface in step S7.

A preferred embodiment of the invention is illustrated by the specific examples shown in Figs. 6-9. Fig. 6 is a 100 x 100 Km DTED plot of the Las Vegas area of Nevada. The dark areas represent areas of lowest elevation, while the light areas represent the higher elevations. Thus, white areas such as that indicated as P1 represent mountain or ridge tops, while black areas such as that indicated as P2 correspond to a local minimums in elevation. In this case, local minimum P2 is a portion of the Grand Canyon.

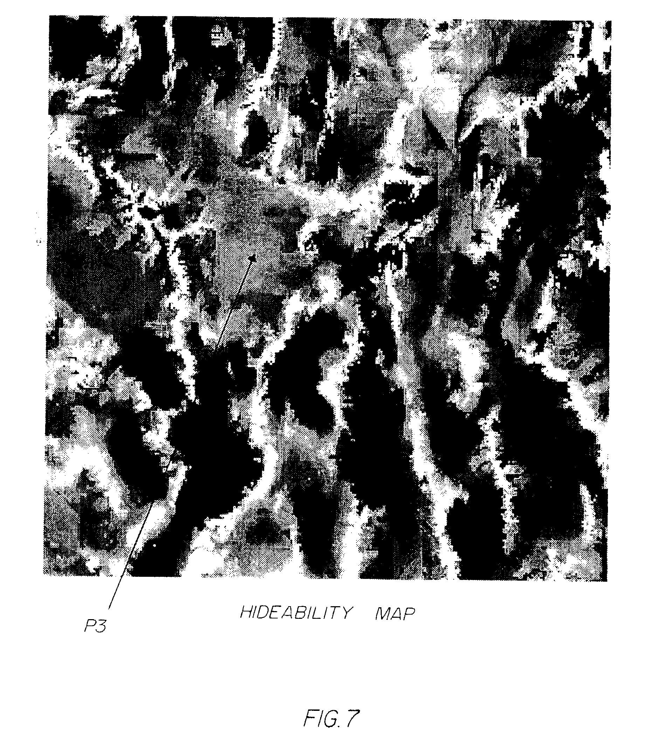

Fig. 7 shows the hideability map formed from the DTED in Fig. 6. Light areas represent areas of least hideability, while dark areas indicate areas which are more hideable, i.e., have greater terrain masking. As illustrated for example by point P3, a point which is in a local terrain minimum according to the DTED may in fact be highly observable. The white portions of the hideability transformation correspond mostly to wide open valleys and ridge tops.

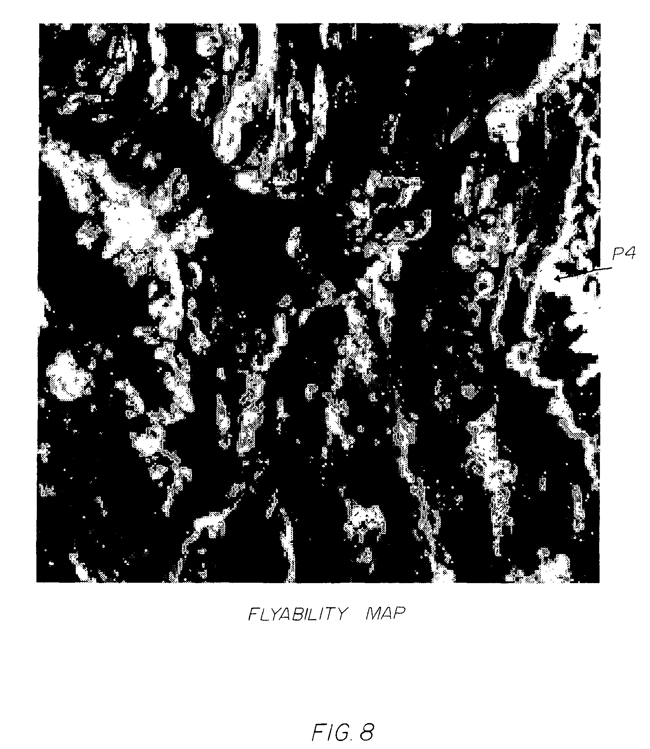

Fig. 8 shows a flyability map formed from the DTED of Fig. 6. In this figure, dark areas represent areas which are relatively flat or "flyable", while light areas represent areas where the terrain is rough. For example, point P4 shown in Fig. 8 illustrates that the terrain in the vicinity of the Grand Canyon is quite rough as would be expected.

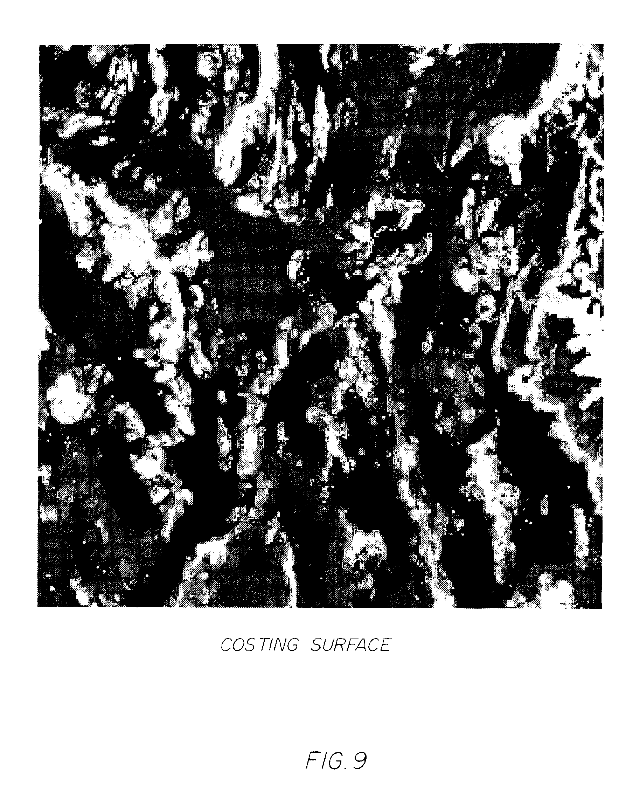

The costing surface which results from the weighted combination of the hideability and the flyability maps is shown in Fig. 9. Here, the value of weighting factors "a" and "b" were chosen to be a=63, b=100. On this costing surface, the darkest areas of the surface indicate those areas which are both hideable and flyable. Thus, the costing surface may be used to effectively route covert flight paths for maximum terrain masking.

**Claims**

1. Apparatus for routing covert flight paths using digital terrain elevation data of a geographical region, the apparatus characterised by:

   means to form a hideability map from the digital terrain elevation data, said hideability map being indicative of hideable areas within the geographical region, said hideability map comprising means to generate said hideability map by using a line of sight area calculation for each point in the digital terrain elevation data in relation to a plurality of surrounding terrain points;

   means to form a flyability map from the digital terrain elevation data, said flyability map being indicative of flyable areas of the geographical region, said flyability map comprising means to generate said flyability map by determining a slopeness calculation value for each point in the digital terrain elevation data in relation to a plurality of surrounding terrain points;

   means to create a costing surface from a weighted combination of said hideability map and said flyability map; and

   means to determine a covert flight path through areas of said costing surface which are both hideable and flyable.

2. Apparatus according to Claim 1 characterised by means to quantize the hideability map and means to quantize the flyability map prior to forming the costing surface.

3. Apparatus to any preceding Claim characterised by means to quantize the hideability map including means to normalize points within the hideability map based on a maximum theoretical value and means to distribute the normalized points into a plurality of quantized levels.

4. Apparatus according to any preceding Claim characterised in that the creating means comprises means to perform the weighted combination in accordance with the following formula where Pq is a point within the costing surface, Hq is a quantized hideability value, Fq is a quantized flyability value, and "a" and "b" represent weighting factors between 0 and 255:

$$Pq = \frac{127}{15} \sqrt{\frac{((a)^2 Hq^2 + (b)^2 Fq^2)}{(a^2 + b^2)}}$$

5. Apparatus according to any of Claims 2 to 4 characterised by means to effect a line of sight area calculation comprising:

   means to perform a ray trace from one point in the digital terrain elevation data to every other point within a circle of a predetermined radius centered on said one point; and
   means to determine how many of the points within the circle are observable from said one point based on the ray trace.

6. Apparatus according to any one of Claims 1 to 5 characterised by hideability quantizing means to quantize said hideability map and flyability quantizing means to quantize said flyability map, said hideability quantizing means comprising means to assign each of said line of sight area values to one of a plurality of quantization levels and said flyability quantizing means comprising means to assign each of said slopeness values to one of a plurality of quantization levels.

7. A method of routing covert flight paths using digital terrain elevation data of a geographical region, the method comprising the steps of:

   forming a hideability map from the digital terrain elevation data, said hideability map being indicative of hideable areas within the geographical region, said hideability map being generated by using a line of sight area calculation for each point in the digital terrain elevation data in relation to a plurality of surrounding terrain points;

   forming a flyability map from the digital terrain elevation data, said flyability map being indicative of flyable areas of the geographical region, said flyability map being generated by determining a slopeness value for each point in the digital terrain elevation data in relation to a plurality of surrounding terrain points;

creating a costing surface from a weighted combination of said hideability map and said flyability map; and

routing a covert flight path through areas of said costing surface which are both hideable and flyable.

8. A method according to Claim 7 characterised by the steps of quantizing the hideability map and quantizing the flyability map prior to forming the costing surface.

9. A method according to Claim 7 or 8 characterised in that the step of quantizing the hideability map includes the steps of normalizing points within the hideability map based on a maximum theoretical value and distributing the normalized points into a plurality of quantized levels.

10. A method according to any of Claims 9 to 13 characterised in that the weighted combination is performed in accordance with the following formula where Pq is a point within the costing surface, Hq is a quantized hideability value, Fq is a quantized flyability value, and "a" and "b" represent weighting factors between 0 and 255:

$$Pq = \frac{127}{15} \sqrt{\frac{((a)^2 Hq^2 + (b)^2 Fq^2)}{(a^2 + b^2)}}$$

11. A method according to any of Claims 7 to 10 characterised in that said line of sight area calculation includes the steps of:

performing a ray trace from one point in the digital terrain elevation data to every other point within a circle of a predetermined radius centered on said one point; and
determining how many of the points within the circle are observable from said one point based on the ray trace.

12. A method according to any of Claims 7 to 11 characterised in that the step of quantizing the hideability map includes the step of assigning each of said line of sight area values to one of a plurality of quantization levels and in that the step of quantizing the flyability map includes the step of assigning each of said slopeness values to one of a plurality of quantization levels.

13. A method according to Claim 12 characterised in that the weighted combination is performed in accordance with the following formula where Pq is a point within the costing surface, Hq is a quantized hideability value, Fq is a quantized flyability value, and "a" and "b" represent weighting factors between 0 and 255:

**Patentansprüche**

1. Vorrichtung zum Führen auf verdeckten Flugstrekken unter Verwendung digitaler Gebiets-Erhebungsdaten eines geographischen Bereichs, wobei die Vorrichtung **gekennzeichnet ist durch :**

Mittel zur Bildung einer verdeckten Landkarte aus den digitalen Gebiets-Erhebungsdaten, wobei die verdeckte Landkarte verdeckte Bereiche innerhalb des geographischen Gebiets anzeigt, wobei die verdeckte Landkarte Mittel zur Erzeugung dieser verdeckten Landkarte unter Verwendung einer Sichtlinien-Bereichsberechnung für jeden Punkt der digitalen Gebiets-Erhebungsdaten in bezug auf eine Vielzahl von Punkten des umgebenden Gebiets aufweist;
Mittel zur Erzeugung einer Flugtauglichkeits-Landkarte aus den digitalen Gebiets-Erhebungsdaten, wobei die Flugtauglichkeits-Landkarte befliegbare Bereiche des geographischen Gebiets anzeigt, wobei die Flugtauglichkeits-Landkarte Mittel zur Erzeugung dieser Flugtauglichkeits-Landkarte durch Bestimmung eines Steigungs-Berechnungswerts für jeden Punkt der digitalen Bereichs-Erhebungsdaten in bezug auf eine Vielzahl von Punkten des umgebenden Gebiets aufweist;
Mittel zur Erzeugung einer vorberechneten Oberfläche aus einer gewichteten Kombination der verdeckten Landkarte und der Flugtauglichkeits-Landkarte; und Mittel zur Bestimmung einer verdeckten Flugstrecke durch Bereiche der vorberechnete Oberfläche, die sowohl verdeckt als auch befliegbar sind.

2. Vorrichtung nach Anspruch 1, **gekennzeichnet durch** Mittel zur Quantifizierung der verdeckten Landkarte und Mittel zur Quantifizierung der Flugfähigkeits-Landkarte vor der Bildung der vorberechneten Oberfläche.

3. Vorrichtung nach einem der vorherstehenden Ansprüche, **gekennzeichnet durch** Mittel zur Quantifizierung der verdeckten Landkarte, umfassend Mittel zur Normierung der Punkte innerhalb der verdeckten Landkarte auf Grundlage eines maximalen theoretischen Werts und Mittel zur Verteilung der normierten Punkte auf eine Vielzahl von quantifizierten Pegeln.

4. Vorrichtung nach einem der vorherstehenden Ansprüche, **dadurch gekennzeichnet,** daß die Erzeugungs-Mittel Mittel zur Bildung der gewichteten Kombination in Übereinstimmung mit der folgenden Formel umfassen, wobei $P_q$ ein Punkt innerhalb der vorberechneten Oberfläche ist, $H_q$ ein quantifizierter verdeckter Wert ist, $F_q$ ein quantifizierter Flugtauglichkeits-Wert ist, und "a" und "b" Gewichtungsfaktoren zwischen 0 und 255 repräsentieren:

$$P_q = \frac{127}{15} \sqrt{\frac{((a)^2 H_q{}^2 + (b)^2 F_q{}^2)}{(a^2 + b^2)}}.$$

5.  Vorrichtung nach einem der Ansprüche 2 bis 4, **gekennzeichnet durch** Mittel zur Ausführung einer Sichtlinien-Bereichsberechnung, umfassend: Mittel zur Ausführung eines Strahlverlaufs zwischen einem Punkt der digitalen Gebiets-Erhebungsdaten zu jedem anderen Punkt innerhalb eines Kreises mit vorbestimmten Radius, der um diesen einen Punkt gezogen ist; und Mittel zur Bestimmung wieviele der Punkte innerhalb des Kreises von diesem einen Punkt auf Grundlage des Strahlenverlaufs sichtbar sind.

6.  Vorrichtung nach einem der Ansprüche 1 bis 5, **gekennzeichnet durch** Verdeckungs-Quantifizierungs-Mittel zur Quantifizierung der verdeckten Landkarte und durch Flugtauglichkeits-Quantifizierungs-Mittel zur Quantifizierung der Flugtauglichkeits-Landkarte, wobei die Verdeckungs-Quantifizierungs-Mittel Mittel umfassen, um jeden der Sichtlinien-Bereichs-Werte einer der Vielzahl der Quantifizierungs-Pegel zuzuordnen, und wobei die Flugtauglichkeits-Quantifizierungs-Mittel Mittel aufweisen, um jeden der Steigungswerte einer der Vielzahl von Quantifizierungs-Pegeln zuzuordnen.

7.  Verfahren zur Führung auf verdeckten Flugstrecken unter Verwendung digitaler Gebiets-Erhebungsdaten eines geographischen Gebiets, wobei das Verfahren die folgenden Schritte umfaßt:

    Bilden einer verdeckten Landkarte aus den digitalen Gebiets-Erhebungsdaten, wobei die verdeckte Landkarte verdeckte Bereiche innerhalb des geographischen Bereichs wiedergibt, wobei die verdeckte Landkarte unter Verwendung einer Sichtlinien-Bereichsberechnung für jeden Punkt innerhalb der digitalen Gebiets-Erhebungsdaten in bezug auf eine Vielzahl von Punkten des umgebenen Gebiets erzeugt wird; Bilden einer Flugtauglichkeits-Landkarte aus den digitalen Gebiets-Erhebungsdaten, wobei die Flugtauglichkeits-Landkarte befliegbare Bereiche des geographischen Gebiets wiedergibt, wobei die Flugtauglichkeits-Landkarte durch Bestimmung eines Steigungswerts für jeden Punkt der digitalen Gebiets-Erhebungsdaten in bezug auf eine Vielzahl von Punkten des umgebenden Gebiets erzeugt wird; Erzeugung einer vorberechneten Oberfläche aus einer gewichteten Kombination der verdeckten Landkarte und der Flugtauglichkeits-Landkarte; und Führen auf verdeckten Flugstrecken durch Bereiche der vorberechnete Oberfläche, die sowohl verdeckt als auch befliegbar sind.

8.  Verfahren nach Anspruch 7, **gekennzeichnet durch** Schritte zur Quantifizierung der verdeckten Landkarte und Quantifizierung der Flugtauglichkeits-Landkarte vor der Erzeugung der vorberechnete Oberfläche.

9.  Verfahren nach Ansprüchen 7 oder 8, **dadurch gekennzeichnet,** daß der Schritt der Quantifizierung der verdeckten Landkarte Schritte zur Normierung der Punkte innerhalb der verdeckten Landkarte auf Basis eines maximalen theoretischen Werts umfaßt, und Schritte zur Verteilung der normierten Punkte auf eine Vielzahl von quantifizierten Pegeln.

10. Verfahren nach einem der Ansprüche 7 bis 9, **dadurch gekennzeichnet,** daß die gewichtete Kombination in Übereinstimmung mit der folgenden Formel erzeugt wird, wobei $P_q$ ein Punkt innerhalb der vorberechnete Oberfläche ist, $H_q$ ein quantifizierter Verdeckungs-Wert ist, $F_q$ ein quantifizierter Flugtauglichkeits-Wert ist, und "a" und "b" Gewichtungsfaktoren zwischen 0 und 255 wiedergeben:

$$P_q = \frac{127}{15} \sqrt{\frac{((a)^2 H_q{}^2 + (b)^2 F_q{}^2)}{(a^2 + b^2)}}.$$

11. Verfahren nach einem der Ansprüche 7 bis 10, **dadurch gekennzeichnet,** daß die Sichtlinien-Bereichsberechnung die folgenden Schritte umfaßt:

    Durchführung eines Strahlverlaufs von einem Punkt innerhalb der digitalen Gebiets-Erhebungsdaten zu jedem anderen Punkt innerhalb eines Kreises von vorbestimmtem Durchmesser, der um diesen Punkt gezogen wird; und Bestimmung, wieviele der Punkte innerhalb des Kreises von dem einen Punkt auf Grundlage des Strahlverlaufs sichtbar sind.

12. Verfahren nach einem der Ansprüche 7 bis 11, **dadurch gekennzeichnet,** daß der Schritt der Quantifizierung der verdeckten Landkarte den Schritt der Zuordnung jedes Sichtlinien-Bereichswerts zu einem Pegel einer Vielzahl von Quantifizierungs-Pegeln umfaßt, und daß der Schritt der Quantifizierung der Flugtauglichkeits-Landkarte den Schritt der Zuordnung jedes Steigungswerts zu einem Pegel einer Vielzahl von Quantifizierungs-Pegeln umfaßt.

13. Verfahren nach Anspruch 12, **dadurch gekennzeichnet,** daß hier die gewichtete Kombination in Übereinstimmung mit der folgenden Formel erzeugt wird, wobei $P_q$ ein Punkt innerhalb der vorberechneten Oberfläche ist, $H_q$ ein quantifizierter Verdeckungs-Wert ist, $F_q$ ein quantifizierter Flugtauglichkeits-Wert ist, und "a" und "b" Gewichtungsfaktoren zwischen 0 und 255 wiedergeben:

$$P_q = \frac{127}{15} \sqrt{\frac{((a)^2 H_q^{\,2} + (b)^2 F_q^{\,2})}{(a^2 + b^2)}}.$$

**Revendications**

1. Dispositif destiné à déterminer des trajets de vol discrets en utilisant des données numériques d'élévation de terrain d'une région géographique, le dispositif étant caractérisé par :

    des moyens destinés à former une carte de possibilité de masquage à partir des données numériques d'élévation de terrain, ladite carte de possibilité de masquage étant représentative de zones pouvant être masquées à l'intérieur de la région géographique, lesdits moyens de formation de carte de possibilité de masquage comprenant des moyens destinés à produire ladite carte de possibilité de masquage en utilisant une ligne de calcul de zone de visibilité directe pour chaque point des données numériques d'élévation de terrain relatifs à une pluralité de points de terrain environnants ;
    des moyens destinés à former une carte de possibilité de survol à partir des données numériques d'élévation de terrain, ladite carte de possibilité de survol étant représentative de zones pouvant être survolées de la région géographique lesdits moyens de formation de carte de possibilité de survol comprenant des moyens destinés à produire ladite carte de possibilité de survol en déterminant une valeur d'inclinaison calculée pour chaque point des données numériques d'élévation de terrain relatifs à une pluralité de points de terrain environnants ;
    des moyens destinés à créer une surface d'évaluation à partir d'une combinaison pondérée de ladite carte de possibilité de masquage et de ladite carte de possibilité de survol ; et
    des moyens destinés à déterminer un trajet de vol discret à travers les zones de ladite surface d'évaluation qui peuvent à la fois être masquées et survolées.

2. Dispositif selon la revendication 1, caractérisé par un moyen destiné à quantifier la carte de possibilité de masquage et un moyen destiné à quantifier la carte de possibilité de survol avant de former la surface d'évaluation.

3. Dispositif selon l'une quelconque des revendications précédentes, caractérisé par un moyen destiné à quantifier la carte de possibilité de masquage comprenant un moyen destiné à normaliser des points à l'intérieur de la carte de possibilité de masquage sur la base d'une valeur théorique maximale et un moyen destiné à répartir les points normalisés en une pluralité de niveaux quantifiés.

4. Dispositif selon l'une quelconque des revendications précédentes, caractérisé en ce que le moyen de création comprend un moyen destiné à exécuter la combinaison pondérée selon la formule suivante dans laquelle Pq est un point situé sur la surface d'évaluation, Hq est une valeur de possibilité de masquage quantifiée, Fq est une valeur de possibilité de survol quantifiée, et "a" et "b" représentent des facteurs de pondération compris entre 0 et 255 :

$$Pq = \frac{127}{15} \sqrt{\frac{((a)^2 Hq^2 + (b)^2 Fq^2)}{(a^2 + b^2)}}$$

5. Dispositif selon l'une quelconque des revendications 2 à 4, caractérisé par un moyen destiné à effectuer une ligne de calcul de zone de visibilité directe comprenant :

    un moyen destiné à exécuter un tracé radial à partir d'un premier point des données numériques d'élévation de terrain vers chaque autre point à l'intérieur d'un cercle d'un rayon prédéterminé centré sur ledit premier point ; et
    un moyen destiné à déterminer le nombre de points à l'intérieur du cercle qui peuvent être observés depuis ledit premier point, sur la base du tracé radial.

6. Dispositif selon l'une quelconque des revendications 1 à 5, caractérisé par un moyen de quantification de possibilité de masquage destiné à quantifier ladite carte de possibilité de masquage et un moyen de quantification de possibilité de survol destiné à quantifier ladite carte de possibilité de survol, ledit moyen de quantification de possibilité de masquage comprenant un moyen destiné à affecter chacune desdites valeurs de la ligne de valeurs de zones de visibilité à l'un d'une pluralité de niveaux de quantification et ledit moyen de quantification de possibilité de survol comprenant un moyen destiné à affecter chacune desdites valeurs d'inclinaison à l'un d'une pluralité de niveaux de quantification.

7. Procédé destiné à déterminer des trajets de vol discrets en utilisant des données numériques d'élévation de terrain d'une région géographique, le procédé comprenant les étapes de :

formation d'une carte de possibilité de masquage à partir des données numériques d'élévation de terrain, ladite carte de possibilité de masquage étant représentative de zones pouvant être masquées à l'intérieur de la région géographique, ladite carte de possibilité de masquage étant produite en utilisant une ligne de calcul de zone de visibilité pour chaque point des données numériques d'élévation de terrain par rapport à une pluralité de points de terrain environnants ;
formation d'une carte de possibilité de survol à partir des données numériques d'élévation de terrain, ladite carte de possibilité de survol étant représentative de zones pouvant être survolées de la région géographique, ladite carte de possibilité de survol étant produite en déterminant une valeur d'inclinaison pour chaque point des données numériques d'élévation de terrain relatif à une pluralité de points de terrain environnants ;
création d'une surface d'évaluation à partir d'une combinaison pondérée de ladite carte de possibilité de masquage et de ladite carte de possibilité de survol ; et
détermination d'un trajet de vol discret à travers les zones de ladite surface d'évaluation qui peuvent à la fois être masquées et survolées.

8. Procédé selon la revendication 7, caractérisé par les étapes de quantification de la carte de possibilité de masquage et de quantification de la carte de possibilité de survol avant de former la surface d'évaluation.

9. Procédé selon la revendication 7 ou 8, caractérisé en ce que l'étape de quantification de la carte de possibilité de masquage comprend les étapes de normalisation des points à l'intérieur de la carte de possibilité de masquage sur la base d'une valeur théorique maximale, et de répartition des points normalisés en une pluralité de niveaux quantifiés.

10. Procédé selon l'une quelconque des revendications 7 à 9, caractérisé en ce que la combinaison pondérée est exécutée selon la formule suivante, dans laquelle Pq est un point situé sur la surface d'évaluation, Hq est une valeur de possibilité de masquage quantifiée, Fq est une valeur de possibilité de survol quantifiée, et "a" et "b" représentent des facteurs de pondération compris entre 0 et 255 :

$$Pq = \frac{127}{15} \sqrt{\frac{((a)^2 Hq^2 + (b)^2 Fq^2)}{(a^2 + b^2)}}$$

11. Procédé selon l'une quelconque des revendications 7 à 10, caractérisé en ce que la ligne de calcul de zone de visibilité comprend les étapes :

d'exécution d'un tracé radial à partir d'un premier point des données numériques d'élévation de terrain vers chaque autre point situé à l'intérieur d'un cercle d'un rayon prédéterminé centré sur ledit premier point ; et
de détermination du nombre de points à l'intérieur du cercle qui peuvent être observés depuis ledit premier point, sur la base du tracé radial.

12. Procédé selon l'une quelconque des revendications 7 à 11, caractérisé en ce que l'étape de quantification de la carte de possibilité de masquage comprend l'étape d'affectation de chaque valeur de la ligne desdites valeurs de zones de visibilité directe à l'un d'une pluralité de niveaux de quantification, et en ce que l'étape de quantification de carte de possibilité de survol comprend l'étape d'affectation de chacune desdites valeurs d'inclinaison à l'un d'une pluralité de niveaux de quantification.

13. Procédé selon la revendication 12, caractérisé en ce que la combinaison pondérée est exécutée selon la formule suivante, dans laquelle Pq est un point situé sur la surface d'évaluation, Hq est une valeur de possibilité de masquage quantifiée, Fq est une valeur de possibilité de survol quantifiée, et "a" et "b" représentent des facteurs de pondération compris entre 0 et 255:

$$Pq = \frac{127}{15} \sqrt{\frac{((a)^2 Hq^2 + (b)^2 Fq^2)}{(a^2 + b^2)}}$$

FIG.1

R1 A R2

B

FIG.2A

R

$C_{n,m}$

FIG.2B

$LOS_1$

$LOS_2$

$C_{n,m}$ p q R

FIG.2C

SET POINT
CLEARANCE

FIG.2D

DISTANT POINT
CLEARANCE

*FIG.3*

```
                    C_{n-1,m-1}
                         ↖        C_{n,m}    ↗ C_{n,m-1}
                    C_{n-1,m} ←        •        → C_{n+1,m-1}
                                                    ↘ C_{n+1,m}
        C_{n-1,m+1} ↙      ↓ C_{n,m+1}   ↘ C_{n+1,m+1}
```

```
                    ┌─────────────┐
                    │   DIGITAL   │
                    │   TERRAIN   │
                    │  ELEVATION  │────  S1
                    │    DATA     │
                    └──────┬──────┘
                           │
              ┌────────────┼────────────┐
              ▼                         ▼
      ┌───────────────┐         ┌───────────────┐
      │   GENERATE    │         │   GENERATE    │
 S2 ──│  HIDEABILITY  │         │   FLYABILITY  │── S4
      │     MAP       │         │     MAP       │
      └───────┬───────┘         └───────┬───────┘
              │                         │
              ▼                         ▼
      ┌───────────────┐         ┌───────────────┐
      │   QUANTIZE    │         │   QUANTIZE    │
 S3 ──│  HIDEABILITY  │         │   FLYABILITY  │── S5
      │     MAP       │         │     MAP       │
      └───────┬───────┘         └───────┬───────┘
              │                         │
              └────────────┬────────────┘
                           ▼
                   ┌───────────────┐
                   │   GENERATE    │
                   │   WEIGHTED    │──  S6
                   │  COMBINATION  │
                   └───────┬───────┘
                           │
                           ▼
                   ┌───────────────┐
                   │   QUANTIZED   │
                   │    COSTING    │──  S7
                   │    SURFACE    │
                   └───────────────┘
```

*FIG.5*

*FIG. 4A*

$B_{i=0}$            $B_{i=100}$

*FIG. 4B*

$B_{i=0}$   $T_1$        $T_{11}$    $B_{i=100}$

DIGITAL TERRAIN ELEVATION
DATA

FIG. 6

HIDEABILITY   MAP

P3

FIG. 7

FLYABILITY MAP

FIG. 8

COSTING SURFACE

FIG. 9